# EUROPEAN PATENT APPLICATION

(11) **EP 4 576 169 A1**
(43) Date of publication of application: **25.06.2025**
(21) Application number: 24219547.7
(22) Date of filing: 12.12.2024
(51) Int. Cl.: H01L 21/265, H10D 84/80, H01L 21/761

(54) **SEMICONDUCTOR DEVICE WITH A DEFECT REGION AND METHOD OF FABRICATION THEREFOR**

(30) Priority: 21.12.2023 US 202318393306
(71) Applicant: NXP B.V., 5656 AG Eindhoven (NL)
(72) Inventor: Magnee, Petrus Hubertus Cornelis, 5656AG Eindhoven (NL); Keys, Joel Edwin, 5656AG Eindhoven (NL)
(74) Representative: Hardingham, Christopher Mark

(57) **Abstract**

Embodiments of semiconductor devices include a semiconductor substrate having a defect region formed in an upper portion of a first semiconductor region, wherein the defect region includes a first implanted species and a second implanted species. A conductive region is formed above the defect region. Embodiments of a method for forming a semiconductor device includes implanting a first species into a first semiconductor region formed within a semiconductor substrate to form a defect region formed in an upper portion of the first semiconductor region, coimplanting a second species into the defect region formed in the first semiconductor region, and forming a conductive region above the defect region.

## Description

### TECHNICAL FIELD

Embodiments of the subject matter described herein relate to semiconductor devices.

### BACKGROUND

Semiconductor devices find application in a wide variety of electronic components and systems. Moreover, useful semiconductor devices for radio frequency (RF), microwave, and millimeter wave applications may include integrated circuits that include integrated passive devices and active devices. Conventional passive device structures within integrated circuits may have high RF losses due to substrate losses. Thus, integrated circuits with reduced substrate losses for passive structures are desired.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a cross sectional side view of a semiconductor device in accordance with an embodiment;
FIG. 2 is a cross sectional side view of a semiconductor device in accordance with an embodiment;
FIG. 3 is a process flow diagram with corresponding cross-sectional views describing a method for fabricating the semiconductor devices of FIGs 1-2, in accordance with an embodiment; and
FIGs 4A and 4B are process flow diagrams with corresponding cross-sectional views describing a method for fabricating the semiconductor devices of FIGs 1-2, in accordance with an embodiment.

### SUMMARY

Embodiments of semiconductor devices, integrated circuits, and methods for forming integrated circuits are disclosed herein. In one aspect, an embodiment may include a semiconductor device that includes semiconductor substrate and a defect region formed in an upper portion of a first semiconductor region formed in the semiconductor substrate. The defect region may include a first species and a second species, according to an embodiment. In an embodiment, a conductive region may be formed above the defect region.

In an embodiment, the first species may include a species that includes at least one of argon, xenon, silicon, germanium, and fluorine. The second species may include at least one of carbon, oxygen, and nitrogen.

In an embodiment, the defect region may include an amorphized material.

In an embodiment, a dielectric region may be formed between the conductive region and the defect region.

In an embodiment, the semiconductor substrate may include a material that includes at least one of silicon, germanium, gallium arsenide, indium phosphide, silicon carbide, and gallium nitride.

In an embodiment, the conductive region may include at least one of a transmission line structure, an inductor structure, a capacitor structure, a coupler structure, a transmission line structure, a coupler structure, a bond pad structure, a shield structure, a transformer structure, a combining network structure, and a splitter structure.

In an embodiment, the conductive region may be included in an integrated passive device formed over the semiconductor substrate.

In an embodiment, a blocking layer may be formed over a second semiconductor region formed within the semiconductor substrate.

In an embodiment, an active device may be formed between the blocking layer and a portion of the first semiconductor region of the semiconductor substrate.

In an embodiment, the active device may include at least one of a field effect transistor, a bipolar transistor, a varactor, a diode, a non-volatile memory element, and a flash memory element.

In another aspect, an embodiment may include an integrated circuit that includes a semiconductor substrate that includes silicon and a defect region that includes an amorphized material formed in an upper portion of a first semiconductor region formed in the semiconductor substrate. In an embodiment, the defect region may include a first species that includes argon and a second species that includes carbon. A conductive region may be formed above the defect region, wherein the conductive region may include a passive device structure that includes at least one of a transmission line structure, an inductor structure, a capacitor structure, and a coupler structure, a bond pad structure, a shield structure, a transformer structure, a combining network structure, and a splitter structure, according to an embodiment. In an embodiment, a dielectric region may be formed between the conductive region and the first semiconductor region.

A blocking layer may be formed between the dielectric region and a portion of the second semiconductor region formed in the semiconductor substrate laterally adjacent the first semiconductor region, according to an embodiment.

An embodiment may include an active device that includes at least one of a field effect transistor, a bipolar transistor, a varactor, and a diode. The active device may be formed between the blocking layer and a portion of the second semiconductor region of the semiconductor substrate, according to an embodiment.

An embodiment may include an active device that includes at least one of a field effect transistor, a bipolar transistor, a varactor, and a diode. The active device may be formed between the dielectric region and a portion of a second semiconductor region of the semiconductor substrate.

In another aspect, an embodiment may include a method for forming an integrated circuit. In an embodiment, the method may include forming a defect region in a semiconductor substrate that may include forming an amorphized material in a first semiconductor region of the semiconductor substrate. Forming the defect region may include implanting a first species into the first semiconductor region and co-implanting a second species into the first semiconductor region, according to an embodiment. An embodiment of the method may include forming a blocking layer over a second semiconductor region of the semiconductor substrate, forming a dielectric region over the defect region, and forming a conductive region over the dielectric region.

In an embodiment of the method, implanting the first species into the defect region may include implanting an ion species that includes at least one of argon, xenon, silicon, germanium, and fluorine. Co-implanting the second species into the defect region may include implanting an ion species that includes at least one of carbon, oxygen, and nitrogen.

In an embodiment of the method, the semiconductor substrate may include a material that includes at least one of silicon, germanium, gallium arsenide, indium phosphide, silicon carbide, and gallium nitride.

In an embodiment of the method, forming the conductive region may include forming a structure that includes forming at least one of a transmission line structure, an inductor structure, a capacitor structure, a coupler structure, a bond pad structure, a shield structure, a transformer structure, a combining network structure, and a splitter structure.

An embodiment of the method may include forming an active device that includes at least one of a field effect transistor, a bipolar transistor, and a diode in the second semiconductor region of the semiconductor substrate.

In an embodiment of the method, forming the dielectric region includes forming the dielectric region after forming the defect region.

### DETAILED DESCRIPTION

Embodiments of semiconductor devices and methods described herein improve substrate losses for passive device structures compared to conventional semiconductor devices by introducing a high resistivity, semi-insulating, or insulating defect region that contains an amorphized material within a portion of a semiconductor substrate in proximity to passive device structures. By using a pre-amorphizing implant of a first species and a co-implant of a second species to form the defect region, the defect region maintains its resistivity during subsequent processing. Thus, passive device structures with low RF loss may be integrated into semiconductor devices more readily.

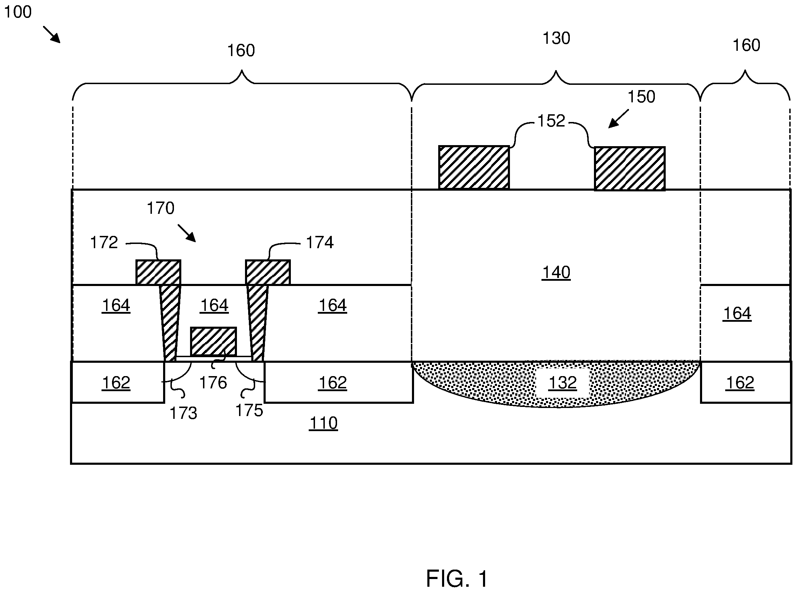

FIG. 1 is a cross sectional side view of an exemplary integrated circuit device 100, according to an embodiment. An embodiment may include an integrated circuit device 100 that includes a semiconductor substrate 110, a first semiconductor region 130 that includes a defect region 132, a dielectric region 140, a conductive region 150, a passive device structure 152, a second semiconductor region 160, a blocking layer 164, and an active device 170.

The semiconductor substrate 110 may be formed from one or more semiconductor and/or insulating materials and may silicon (Si), germanium (Ge), silicon germanium (SiGe), gallium arsenide (GaAs), gallium phosphide (GaP), indium gallium phosphide (InGaP), indium phosphide (InP), gallium nitride (GaN), aluminum nitride (AlN), indium nitride (InN), silicon carbide (SiC), sapphire, or other suitable materials. In an embodiment, semiconductor substrate 110 may include single crystal material (e.g., single crystal Si). In other embodiments, semiconductor substrate may include single crystal and/or poly crystalline materials (e.g., Si on insulator (SOI)). In an embodiment, semiconductor substrate 110 may have a thickness between about 1 micron and about 1000 microns, although other thicker or thinner layers may be used.

The first semiconductor region 130 may be formed within the semiconductor substrate 110. As used herein, the term, "semiconductor region" may refer to single or multiple semiconductor regions that may include regions formed by bulk crystal growth, implantation (e.g., ion implantation) or by epitaxial growth. The first semiconductor region 130 may be defined by defect region 132, according to an embodiment. Defect region 132 may include an amorphized material. As used herein, the term "amorphized material" means a single crystal material that has been converted into an amorphous material. The defect region 132 may include a first species and a second species (e.g., formed by ion implantation), according to an embodiment. In an embodiment, the first species used to form defect region 132 may include argon (Ar), germanium (Ge), silicon (Si), xenon (Xe), or other suitable ion species. The second species used to form defect region 132 may include carbon (C), oxygen (O), nitrogen (N), or other suitable ion species. In some embodiments wherein semiconductor substrate 110 is substantially Si, C may be preferred as the second species. In an embodiment (e.g., semiconductor substrate 110 is substantially Si), the amorphized material within the defect region 132 may render defect region 132 substantially high resistivity and may have a resistivity between about 1e3 (500) ohm-cm and about 1e8 ohm-cm, according to an embodiment. In still other embodiments, (e.g., semiconductor substrate 110 includes GaN) defect region 132 may be substantially semi-insulating and may have a resistivity between about 1e5 ohm-cm and about 1e12 ohm-cm, though higher or lower resistivity values may be used. In some embodiments, defect region 132 may have a thickness between about 1000 angstroms and about 5000 angstroms, although other thicknesses may be used. In other embodiments, defect region 132 may have a thickness between about 100 angstroms and about 10000 angstroms, although other thicknesses may be used.

In an embodiment, a dielectric region 140 may be formed between the conductive region 150 and the defect region 132. Dielectric region 140 may include one or more dielectric layers and may be configured as an interlayer dielectric, according to an embodiment. In an embodiment, dielectric region 140 may be formed using one or more of one or more layers of silicon dioxide (SiOₓ), tetra-ethyl orthosilicate (TEOS), silicon nitride (Si_{X}N_{Y}), silicon oxynitride (SiON), aluminum oxide (Al₂O₃), aluminum nitride (AlN), polyimide, benzocyclobutene (BCB), spin-on glass, undoped Si glass (USG), phosphorous-doped Si glass (PSG), and borophosphosilicate glass (BPSG), or other suitable materials. Dielectric region 140 may have a thickness of between about 1000 angstroms and about 10000 angstroms, according to an embodiment. In other embodiments, dielectric region 140 may have a thickness of between about 500 angstroms and about 100000 angstroms, although other thicknesses may be used.

A conductive region 150 may be formed above the defect region 132, according to an embodiment. In an embodiment, the conductive region 150 may include a passive device structure 152. In an embodiment, passive device structure 152 may include a transmission line structure, an inductor structure, a capacitor structure, a coupler structure, bond pad structure, shield structure, transformer structure, combining network structure, splitter structure, or other appropriate passive device structures. In an embodiment, the presence of defect region 132 beneath conductive region 150 and passive device structure 152 may reduce RF losses in passive device structure 152 that arise from fringing fields that may emanate from passive device structure 152 and into semiconductor substrate 110.

Second semiconductor region 160 may be formed within semiconductor substrate 110, according to an embodiment. Second semiconductor region 160 may be partially defined by isolation regions 162 formed within semiconductor substrate 110, according to an embodiment. In some embodiments, isolation regions 162 may be formed using regions rendered insulating or semi-insulating by crystal damage due to implant isolation. In other embodiments, isolation regions 162 may include etched or trench regions formed by etching and filled by one or more dielectric materials (e.g., oxide).

A blocking layer 164 may be formed within a second semiconductor region 160 formed within the semiconductor substrate 110, according to an embodiment. In an embodiment, blocking layer 164 may include substantially insulating materials that may be used to protect active devices described hereafter during the formation of defect region 132. In an embodiment, blocking layer 164 may be formed using one or more of one or more of SiO_{X}, TEOS, Si_{X}N_{Y}, SiON, Al₂O₃, AlN, polyimide, BCB, spin-on glass, Si glass (USG), phosphorous-doped Si glass (PSG), and borophosphosilicate glass (BPSG), or other suitable dielectric material(s). Blocking layer region 164 may have a thickness of between about 1000 angstroms and about 10000 angstroms, according to an embodiment. In other embodiments, blocking layer 164 may have a thickness of between about 500 angstroms and about 100000 angstroms, although other thicknesses may be used. In still other embodiments (not shown), blocking layer 164 may be formed using a resist or hard mask layer and may be removed before formation of integrated circuit device 100 is complete.

In an embodiment, an active device 170 may be formed within second semiconductor region 160. As used herein, the term "active device" means a device structure that relies on current flow or capacitance provided by a semiconductor material. In an embodiment, active device 170 may be formed within the blocking layer 164 and the second semiconductor region 160 of the semiconductor substrate 110. Active device 170 may include one or more of field effect transistors, a bipolar transistors, resistors, varactors, and diodes, non-volatile memory elements, and flash memory elements, although other devices may be used.

In the example embodiment of FIG. 1, active device 170 may include a field effect transistor that includes a source electrode 172, a drain electrode 174, and a gate electrode 176. Source and drain electrodes 172, 174 may contact source and drain regions 173 and 175 formed within semiconductor substrate 110. Gate electrode 176 may be formed over semiconductor substrate 110 and may control the flow of current between source electrode 172 and drain electrode 174. In other embodiments (not shown), bipolar transistors, diodes and varactors may be used in place or addition to the field effect transistor illustrated in this example embodiment. The presence of the blocking layer 164 between portions of active device 170 and first semiconductor region 130 provides protection of critical elements (i.e., source and drain regions 173, 175 and gate electrode 176) from ion implantation from the formation of defect region 132.

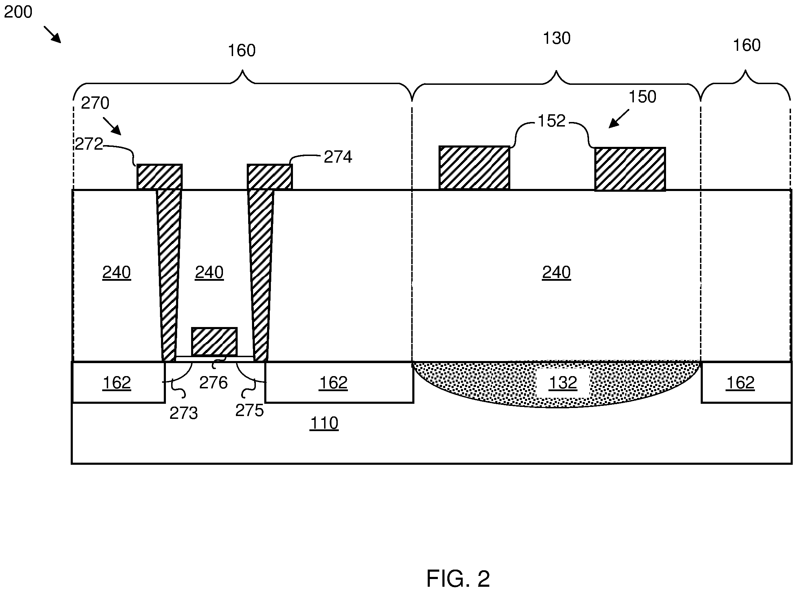

FIG. 2 is a cross sectional side view of an exemplary integrated circuit device 200, according to an embodiment. An embodiment may include an integrated circuit device 100 that includes a semiconductor substrate 110, a first semiconductor region 130 that includes a defect region 132, a dielectric region 240, a conductive region 150, a passive device structure 152, a second semiconductor region 160, and an active device 270. Integrated circuit device 200 contains numbered items with substantially the same form and function as integrated circuit device 100, except where a leading "2" is used for number references (e.g., dielectric region 240, active device 270, source region 273, source electrode 274, drain region 275, drain electrode 276, gate electrode 276).

In an embodiment, an active device 270 may be formed within second semiconductor region 160. Active device 270 may include one or more of field effect transistors, a bipolar transistors, varactors, and diodes, non-volatile memory elements, and flash memory elements, although other devices may be used.

In an embodiment, a dielectric region 240 may be formed between the conductive region 150 and the defect region 132 in the first semiconductor region 130. Dielectric region 240 may include one or more dielectric layers and may be configured as an interlayer dielectric, according to an embodiment. In an embodiment, dielectric region 240 may be formed using one or more of one or more of SiOₓ, TEOS, Si_{X}N_{Y}, SiON, Al₂O₃, and AlN), polyimide, BCB, spin-on glass Si glass (USG), phosphorous-doped Si glass (PSG), and borophosphosilicate glass (BPSG), or other suitable dielectric material(s). Dielectric region 240 may have a thickness of between about 1000 angstroms and about 10000 angstroms, according to an embodiment. In other embodiments, dielectric region 140 may have a thickness of between about 500 angstroms and about 100000 angstroms, although other thicknesses may be used.

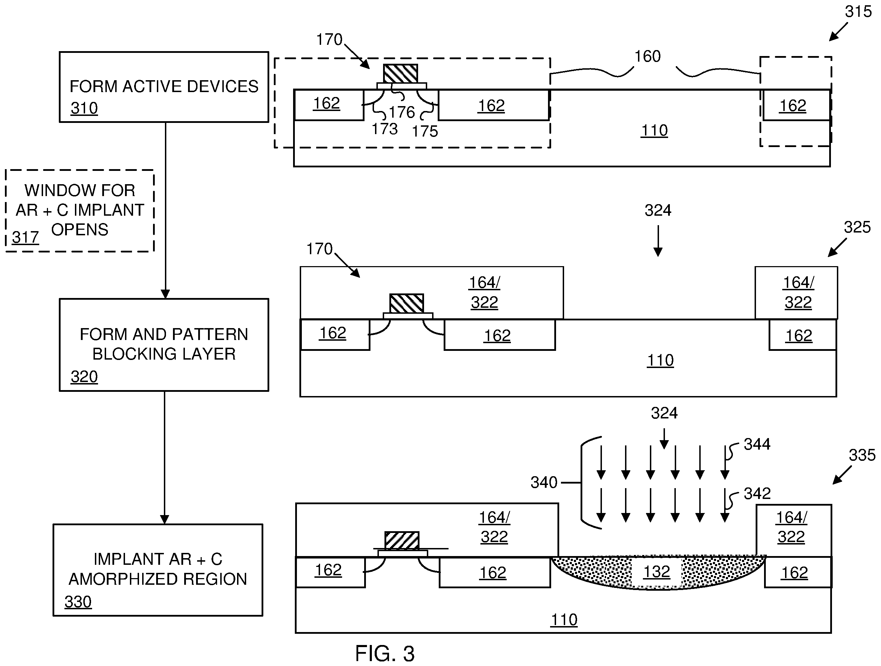

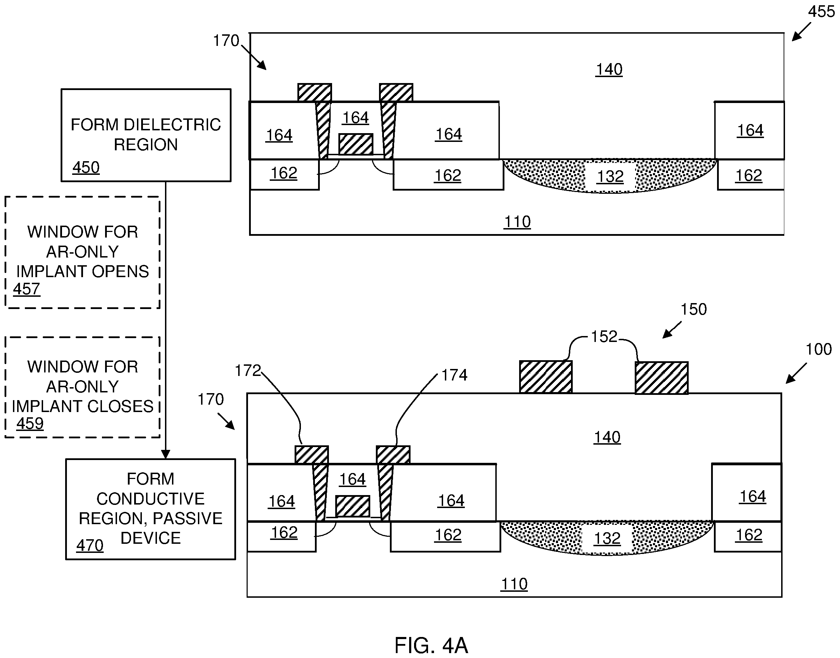

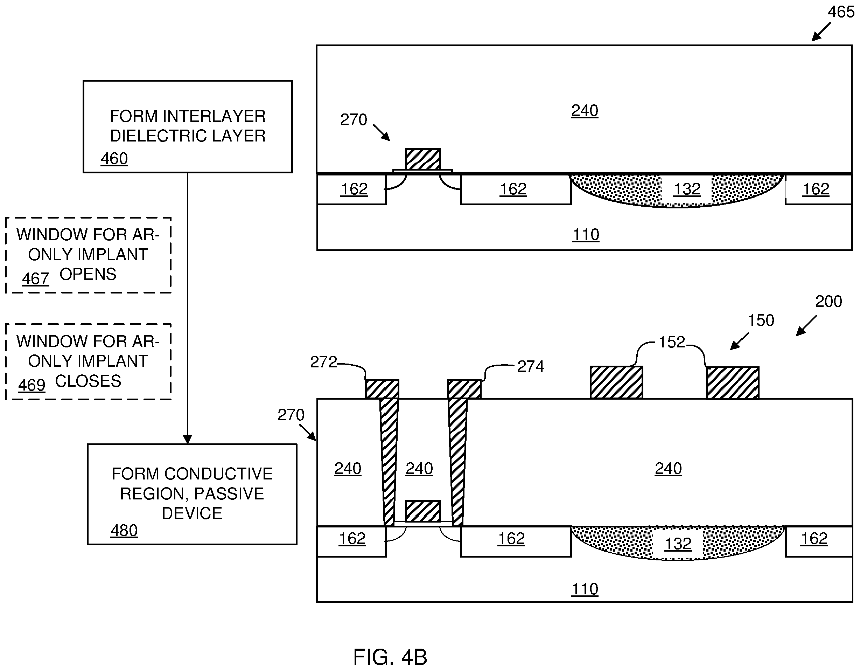

FIGs 3, 4A, and 4B depict a process flow diagrams with corresponding cross-sectional views describing a method for fabricating the integrated circuit devices of FIGs 1 and 2, in accordance with an embodiment. The method includes a sequence of steps, for which only the salient are shown for convenience in illustration. The ordering of the acts may vary in other embodiments.

Referring to FIG. 3, step 310, an embodiment of the method may include forming portions of active device 170. In an embodiment, forming portions of active device 170 may include forming second semiconductor region 160 by forming isolation regions 162, source and drain regions 173, 175, and gate electrode 176. Structure 315 results.

Referring to FIG. 3, indicator 317, after structure 315 is formed, it is possible to form defect region 132 using Ar followed by C co-implants with minimally low degradation of resistivity due to re-crystallization of the amorphized material within defect region 132, as a result of thermal exposure during subsequent processing, according to an embodiment. This resistance to re-crystallization due to high temperature exposure during subsequent processing is a result the first and second species used to form the amorphized material in defect region 132 allow, according to an embodiment. In an embodiment, the co-implanted C (or O) atoms interact with the dangling Si-bonds in the amorphized/polycrystalline material in the defective layer, pinning the defects, thereby slowing down the recrystallization with exposure to temperatures above, e.g., 600C. Stated another way, it takes more energy (higher temperature) for the Si to move to recrystallize an reduce the resistivity of defect region 132 compared to a defect layer created only with Ar implant, according to an embodiment.

Referring to FIG. 3, step 320, an embodiment of the method may include forming blocking layer 164/322. The numbered reference of blocking layer 164/322 denotes that it may be possible to either deposit blocking layer 164 as referred to in the foregoing description in connection with integrated circuit device 100 of FIG. 1, or as a sacrificial blocking layer 322 used in the fabrication of integrated circuit device 200 of FIG. 2, as described below, according to an embodiment.

Still referring to FIG. 3, step 320, in an embodiment, forming blocking layer 164 may include depositing one or more dielectric materials over semiconductor substrate 110 and patterning. Blocking layer 164 may be formed using low pressure chemical vapor deposition (LPCVD), chemical vapor deposition (CVD), physical vapor deposition (PVD), sputtering, evaporation, spin coating, or other suitable techniques, according to an embodiment. Opening 324 may be formed in blocking layer 164 by patterning a masking layer (e.g., using photo lithography, not shown) and using dry etching (e.g., reactive ion etching) or wet etching technique(s) to form opening 324. Structure 325 results.

In an embodiment of the method of forming integrated circuit device 200 of FIG. 2, sacrificial blocking layer 322 (i.e., "blocking layer") may be formed over semiconductor substrate 110 by dispensing and patterning a resist layer (e.g., photo resist) or other suitable sacrificial material to form opening 324. Structure 325 results.

Referring to FIG. 3, step 330, an embodiment of the method may include creating defect region 132 by amorphizing a portion of semiconductor substrate 110 within first semiconductor region 130 through opening 324 using implantation doses 340. An embodiment of the method may include implanting a first species as a pre-amorphizing implant 342 and a second species as co-implant 344 into semiconductor substrate 110 to create defect region 132. The pre-amorphizing implant 342 that may include, e.g., argon (Ar), Si, or Ge. After the pre-amorphizing implant 342, e.g., Ar, the co-implant 344, e.g., C, may be used to complete formation of defect region 132. As a result of the pre-amorphizing implant 342 and the co-implant 344, an amorphous region may be formed within defect region 132. In an exemplary embodiment, an implant schedule included in ion implantation doses 340 may include an implant schedule that includes a one or more doses. In an embodiment, the first dose corresponding to the pre-amorphizing implant 342 may include an areal concentration between about 1e14 cm⁻² and about 1e16 cm⁻² and an energy between about 50 thousand electron volts (keV) and about 500 keV. The second dose corresponding to the co-implant 344 may include an areal concentration between about 1e14 cm⁻² and between about 1e16 cm⁻² and an energy between about 50 keV and about 300 keV, according to an embodiment. In other embodiments, greater or fewer numbers of doses and or doses with higher or lower areal concentrations and energies may be used without limitation to achieve the requirements of any specific embodiments. For example, in some embodiments, the first species, e.g., Ar may be "sandwiched" between co-implants of the second species, e.g., C to allow for the second species to tie up dangling bonds, e.g., Si bonds, caused by damage introduced by the first species in the pre-amorphizing implant 342 in the semiconductor substrate. Furthermore, it should be appreciated that the nomenclature, "first species," "second species," "pre-amorphizing implant," and "co-implant" do not necessarily impart a specific order to the implant schedule of implantation doses 340. The implantation doses 340 may be performed in any order and with any repetition needed to achieve the desired characteristics of defect region 132. In an embodiment, the pre-amorphizing implant 342 and co-implant 344 approaches the solubility limit for the species in the semiconductor substrate 110 (e.g., Si). In an embodiment, the relatively high concentration of species incorporated as point defects into the crystal lattice of the semiconductor substrate 110 may create an amorphous region within the defect region 132 since the high species concentration may create amorphous pockets within the crystal lattice of the semiconductor substrate 110 in first semiconductor region 130, creating an amorphized material, and render the defect region 132 amorphous. Structure 335 results.

Referring now to FIG. 4A, steps 450, 460, a series of fabrication steps for forming integrated circuit device 100 is depicted. Referring now to step 450, dielectric region 140 may be formed over active device 170, blocking layer 164, and over defect region 132 in semiconductor substrate 110. Dielectric region 140 may be formed using LPCVD, chemical vapor deposition (CVD), PVD, sputtering, evaporation, spin coating, or other suitable techniques, according to an embodiment. In an embodiment, dielectric region 140 may be planarized using chemical-mechanical polishing or other suitable technique. Structure 455 results.

Referring to FIG. 4A, indicators 457, 459, after structure 455 is formed, it may be possible to form defect region 132 using Ar only without significant loss of resistivity. However, were Ar-only to be used to create a defect region, openings would need to be made in dielectric region 140 to allow implantation and lower temperature dielectric materials (e.g., BCB) would need to be used to form passive elements above this defect region to prevent loss of resistivity of semiconductor substrate 110 with exposure to high temperature processing.

Referring now to FIG. 4B, step 460, conductive region 150 may be formed over dielectric region 140 to form passive device structure 152, according to an embodiment. In an embodiment, passive device structure 152 may be formed by depositing one or more metal layers formed using PVD, sputtering, evaporation, or other suitable technique(s). Integrated circuit device 100 results.

Referring now to FIG. 4B, steps 460, 480, a series of fabrication steps for forming integrated circuit device 200 is depicted. Referring now to step 470, dielectric region 240 may be formed over active device 270 and over defect region 132 in semiconductor substrate 110. Dielectric region 240 may be formed using low pressure chemical vapor deposition (LPCVD), chemical vapor deposition (CVD), physical vapor deposition (PVD), sputtering, evaporation, spin coating, or other suitable techniques, according to an embodiment. In an embodiment, dielectric region 240 may be planarized using chemical-mechanical polishing or other suitable technique. Structure 465 results.

Referring to FIG. 4B, indicators 467, 469, after structure 465 is formed, as shown in indicator 467, a window in the process opens wherein it is possible to form defect region 132 using Ar implant(s) only without exposure to the prior high temperature steps such as forming dielectric region 140. However, were Ar-only to be used for the implant, openings (not shown) would need to be made in dielectric region 140 and lower temperature dielectric materials (e.g., BCB) would need to be used to form passive elements above a defect region created using Ar-only (not shown). Moreover, as shown in in indicator 469, the window in the process closes after this point since subsequent layers need to be applied and it becomes impractical to make openings in dielectric region 140 that can be used for implantation into semiconductor substrate 110 (not shown).

Referring now to FIG. 4B, step 480, conductive region 150 may be formed over dielectric region 240 to form passive device structure 152, according to an embodiment. In an embodiment, conductive region 150 may be formed by depositing one or more metal layers formed using PVD, sputtering, evaporation, plating, or other suitable technique(s). Conductive region 150 may be patterned using etching or other suitable techniques to form passive device structure 152. Source and drain terminals 272, 274 may be formed in dielectric region 240. Integrated circuit device 200 results.

The following detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary, or an example is not necessarily to be construed as preferred or advantageous over other implementations. Furthermore, there is no intention to be bound by any expressed or implied theory presented in the preceding technical field, background, or the following detailed description.

For the sake of brevity, conventional semiconductor fabrication techniques may not be described in detail herein. In addition, certain terminology may also be used herein for reference only, and thus are not intended to be limiting, and the terms "first," "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A semiconductor device comprising:
a semiconductor substrate;
a defect region formed in an upper portion of a first semiconductor region formed in the semiconductor substrate, wherein the defect region includes a first species and a second species; and
a conductive region formed above the defect region.

2. The semiconductor device of claim 1, wherein the first species includes a species selected from the group consisting of argon, xenon, silicon, germanium, and fluorine, and wherein the second species includes a species selected from the group consisting of carbon, oxygen, and nitrogen.

3. The semiconductor device of claim 1 or 2, wherein the defect region includes an amorphized material.

4. The semiconductor device of any preceding claim, further comprising a dielectric region formed between the conductive region and the defect region.

5. The semiconductor device of any preceding claim, wherein the semiconductor substrate includes a material selected from the group consisting of silicon, germanium, gallium arsenide, indium phosphide, silicon carbide, and gallium nitride.

6. The semiconductor device of any preceding claim, wherein the conductive region includes a structure selected from the group consisting of a transmission line structure, an inductor structure, a capacitor structure, a coupler structure, a transmission line structure, a coupler structure, a bond pad structure, a shield structure, a transformer structure, a combining network structure, and a splitter structure.

7. The semiconductor device of claim 6, wherein the conductive region is included in an integrated passive device formed over the semiconductor substrate.

8. The semiconductor device of any preceding claim, further comprising a blocking layer formed over a second semiconductor region formed within the semiconductor substrate.

9. The semiconductor device of claim 8, further comprising an active device formed between the blocking layer and a portion of the first semiconductor region of the semiconductor substrate.

10. The semiconductor device of claim 9, wherein the active device includes a device selected from the group consisting of a field effect transistor, a bipolar transistor, a varactor, a diode, non-volatile memory, and flash memory.

11. A method for forming an integrated circuit, the method comprising:
forming a defect region in a semiconductor substrate that includes forming an amorphized material in a first semiconductor region of the semiconductor substrate, wherein forming the defect region includes implanting a first species into the first semiconductor region and co-implanting a second species into the first semiconductor region;
forming a blocking layer over a second semiconductor region of the semiconductor substrate;
forming a dielectric region over the defect region; and
forming a conductive region over the dielectric region.

12. The method of claim 11, wherein implanting the first species into the defect region includes implanting an ion species selected from the group consisting of argon, xenon, silicon, germanium, and fluorine and, wherein co-implanting the second species into the defect region includes implanting an ion species selected from the group consisting of carbon, oxygen, and nitrogen.

13. The method of claim 11 or 12, wherein the semiconductor substrate includes a material selected from the group consisting of silicon, germanium, gallium arsenide, indium phosphide, silicon carbide, and gallium nitride.

14. The method of any of claims 11 to 13, wherein forming the conductive region includes forming a structure selected from the group consisting of a transmission line structure, an inductor structure, a capacitor structure, a coupler structure, a bond pad structure, a shield structure, a transformer structure, a combining network structure, and a splitter structure.

15. The method of any of claims 11 to 14, further comprising forming an active device selected from the group consisting of a field effect transistor, a bipolar transistor, and a diode in the second semiconductor region of the semiconductor substrate.
